# EUROPÄISCHE PATENTSCHRIFT

(11) **EP 1 060 541 B1**
(45) Veröffentlichungstag und Bekanntmachung des Hinweises auf die Patenterteilung: **07.05.2003**
(21) Anmeldenummer: 99914411.6
(22) Anmeldetag: 05.02.1999
(51) Int. Cl.: H01S 5/02, H01S 5/10

(54) **BAUELEMENT MIT EINER LASERDIODE UND EINEM LICHTEMPFÄNGER**
COMPONENT WITH A LASER DIODE AND A LIGHT RECEIVER
COMPOSANT POURVU D'UNE DIODE LASER ET D'UN RECEPTEUR DE LUMIERE

(30) Priorität: 18.02.1998 DE 19807783
(43) Veröffentlichungstag der Anmeldung: 20.12.2000
(73) Patentinhaber: SIEMENS AKTIENGESELLSCHAFT, 80333 München (DE)
(72) Erfinder: WIPIEJEWSKI, Torsten, D-93049 Regensburg (DE)
(74) Vertreter: Müller, Wolfram Hubertus, Dipl.-Phys.
(86) Internationale Anmeldenummer: DE9900379
(87) Internationale Veröffentlichungsnummer: WO99043056

(56) Entgegenhaltungen:
- EP-A- 0 645 827
- EP-A- 0 765 013
- EP-A- 0 899 836
- THIBEAULT B J ET AL: "REDUCED OPTICAL SCATTERING LOSS IN VERTICAL-CAVITY LASERS USING A THIN (300 A) OXIDE APERTURE" IEEE PHOTONICS TECHNOLOGY LETTERS, Bd. 8, Nr. 5, 1. Mai 1996 (1996-05-01), Seiten 593-595, XP000589250 ISSN: 1041-1135 in der Anmeldung erwähnt
- LIM, S.F. ET AL.: "Intracavity resonant quantum-well photodetection of a vertical-cavity surface-emitting laser" ELECTRONICS LETTERS, 27. März 1997 (1997-03-27), Seiten 597-598, XP002109872 in der Anmeldung erwähnt
- HASNAIN G. ET AL: 'Monolithic integration of photodetector with vertical cavity surface emitting laser' ELECTRONICS LETTERS Bd. 27, Nr. 18, 29 August 1991, Seiten 1630 - 1632

## Beschreibung

Die Erfindung liegt auf dem Gebiet der Optoelektronik und ist bei der Gestaltung der Schichtenfolge eines eine Heterostruktur aufweisenden Bauelementes anzuwenden, bei dem auf einem Substrat wenigstens eine Laserdiode, die Licht mit einer Emissionswellenlänge λ emittiert, und wenigstens ein Lichtempfänger monolithisch übereinander angeordnet sind.

Bei den Laserdioden handelt es sich hierbei vorzugsweise um Vertikalresonator-Laserdioden (Vertical Cavity Surface Emitting Laser; VCSEL). Für die verschiedenen Schichten einer solchen Laserdiode wird zwar dasselbe Materialsystem wie zum Beispiel AlₓGa₁₋ₓAs verwendet, doch wird durch Variation des Gehaltes (x; 1-x) einer oder mehrerer Materialkomponenten sowohl die chemische Zusammensetzung als auch die Energielücke zwischen den einzelnen Schichten variiert. Vorzugsweise wird eine Vertikalresonator-Laserdiode so aufgebaut, daß sich an eine für den Lasereffekt notwendige aktive Zone ein Bereich aus einem Material mit einer größeren Energielücke anschließt. Hierdurch kann die Ladungsträgerrekombination auf einen schmaleren Bereich eingeengt und damit die zum Einsetzen einer Lasertätigkeit notwendige Pumpstromdichte deutlich reduziert werden.

Aus der EP 0 645 827 A2 ist ein Optokoppler mit hybridem Aufbau bekannt. Dieser Optokoppler weist einen Empfängerchip auf, der über ein optisches Koppelmedium mit einem darüber angeordneten Senderchip verbunden ist. Das optische Koppelmedium dient zur elektrischen Isolierung zwischen Sende- und Empfängerchip, wobei das optische Koppelmedium für das vom Sendechip emittierte Licht transparent ist. Im Gegensatz zur monolithischen Herstellung optoelektronischer Bauelemente ist die Herstellung derartiger hybrider Bauformen wegen der notwendigen zusätzlichen Montage der Einzelelemente oftmals kostenintensiver.

Vertikalresonator-Laserdioden (VCSEL) ermöglichen hingegen eine relativ einfache vertikale Integration mit anderen optoelektronischen Bauelementen. Monolithisch integrierte Photodetektoren werden beispielsweise benötigt, um die optische Ausgangsleistung der Sendeelemente auf einen konstanten Wert einregeln zu können. Hierbei erfaßt der Lichtempfänger (beispielsweise Monitor-Photodiode) die optische Ausgangsleistung des Laserdiode und speist diese in einen Steuerkreis ein. Ferner ist es bekannt, die ermittelte Ausgangsleistung der Laserdiode zu seiner Steuerung einzusetzen.

Bei einem bekannten Bauelement dieser Art besteht.sowohl die auf dem Substrat angeordnete Laserdiode als auch der innerhalb der Laserdiode angeordnete Lichtempfänger jeweils aus mehreren übereinander gitterangepaßt epitaktisch aufgewachsenen Halbleiterschichten. Innerhalb der Laserdiode ist eine der Halbleiterschichten nach dem Aufwachsen aller Schichten einer seitlich einwirkenden chemischen Reaktion in Form eines Oxidationsprozesses nur soweit in eine Oxidschicht umgewandelt, daß mittig eine Apertur freibleibt. Diese Oxidschicht dient zu einer lateralen Strombegrenzung für den Laserstrom (Artikel von LIM, S.F. u.a.: Intracavity resonant quantum-well photodetection of a vertical-cavity surface-emitting laser. In: Electronic Letters, Vol. 33, No. 7, S. 597 - 598). - Auch andere bekannte VCSEL Bauelemente weisen eine mit einer Apertur versehene elektrisch isolierende Schicht auf, die zu einer lateralen Strombegrenzung für den Laserstrom dient. (Druckschriften: FLOYD, P.D: u.a.: Comparison of optical losses in dielectricapertured vertical-cavity lasers, IEEE Photonics Technology Letters, 1996, Vol. 8, No. 5, S. 590 - 592, DS 3: THIBEAULT, B.J. u.a.: Reduced optical scattering loss in vertical-cavity lasers using a thin (300 A) oxide aperture, IEEE Photonics Technology Letters, 1996, Vol. 8, No. 5, S. 593 - 595 und DS 4: DEPPE, D.G. u.a.: Eigenmode confinement in the dielectrically apertured Fabry-Perot microcavity. In: IEEE. Photonics Technology Letters, 1997, Vol. 9, No. 6, S. 713 - 715).

Bei einem anderen Bauelement, bei dem Laserdiode und Lichtempfänger monolithisch übereinander angeordnet sind gemäß dem Oberbegriff des Anspruchs 1 oder 5 , befindet sich der Lichtempfänger auf einer der Lichtaustrittsfläche entgegengesetzten Seite des Bauelements. Bei dieser Zuordnung von Lichtempfänger und Laserdiode wird die Lichtstrahlung, die nicht für den Lasereffekt ausgenutzt werden kann, zur Detektion der Leistung des Laserdiode eingesetzt (WO 95/18479).

Aus der nachveröffentlichten EP 0 899 836 A1 ist ebenfalls ein gattungsgemäßes Bauelement mit monolithisch übereinander angeordnetem VCSEL und Photodiode bekannt.

Bei den bekannten Bauelementen mit monolithisch übereinander angeordneten Laserdioden in Form von Vertikalresonator-Laserdioden und Lichtempfängern in Form von Photodioden ist der gemessene Photostrom nicht proportional zur emittierten Lichtleistung des Lasers, wodurch die Regelung der Ausgangsleistung der Vertikalresonator-Laserdiode einer Ungenauigkeit unterliegt.

Die in dem obengenannten Artikel von LIM S.F. (Electronics Letters, Vol.33, No.7, S.597-598) zitierte Referenz 1, Electronics Letters, 29 August 1991, Vol. 27, No.18, S.1630-1632, beschreibt ein Bauelement mit einem GaAs-Substrat, auf dem eine als Lichtempfänger dienende Quantum-Well-Photodiode über einem VCSEL monolithisch angeordnet ist, gemäß dem Oberbegriff des Anspruchs 1 oder 5.

Ausgehend von einem Bauelement mit den Merkmalen des Oberbegriffs des Patentanspruchs 1 und einem Verfahren zur Herstellung eines solchen Bauelementes liegt der Erfindung die Aufgabe zugrunde, das Bauelement so auszugestalten und herzustellen, daß eine genaue Regelung der Ausgangsleistung der Laserdiode möglich ist.

Erfindungsgemäß wird diese Aufgabe dadurch gelöst, daß zwischen den Halbleiterschichten, die die Laserdiode bilden, und den Halbleiterschichten, die den Lichtempfänger bilden, wenigstens eine semitransparente optische Funktionsschicht zur optischen und elektrischen Entkopplung zwischen Laserdiode und Lichtempfänger monolithisch integriert ist, die aus einem gitterangepaßt epitaktisch abgeschiedenen und nachfolgend chemisch veränderten Halbleitermaterial besteht und einen Brechungsindex von höchstens 2,5 aufweist, wobei die der semitransparenten optischen Funktionsschicht benachbarte Halbleiterschicht der Laserdiode einen im Vergleich mit der semitransparenten Funktionsschicht größeren Brechungsindex aufweist.

Die gemäß der Erfindung vorgesehene semitransparente optische Funktionsschicht bewirkt eine optische Entkopplung zwischen der Laserdiode und dem Lichtempfänger, weil aufgrund des relativ niedrigen Brechungsindexes der semitransparenten optischen Funktionsschicht der Einfluß der in der aktiven Zone eines Halbleiterlasers erzeugten spontanen Emission auf den Lichtempfänger verringert ist.

Ein Brechungsindex der semitransparenten optischen Funktionsschicht von höchstens 2,5 läßt sich vorzugsweise dadurch erzielen, daß die semitransparente optische Funktionsschicht ein Oxid eines Aluminium-haltigen Halbleitermaterials aufweist. - Oxide haben neben ihrer einfachen Integrierbarkeit in den Herstellungsprozeß des Bauelementes beziehungsweise einer dieses Bauelement enthaltenden elektrischen Schaltung den Vorteil, daß sie eine elektrische Isolation zwischen der Laserdiode und dem Lichtempfänger ermöglichen. Durch diese elektrische Isolation ist es möglich, die Laserdiode und den Lichtempfänger unabhängig voneinander elektrisch anzusteuern. - Besonders geeignete Bestandteile der semitransparenten optischen Funktionsschicht sind Al₂O₃ oder (Ga₁₋ₓAlₓ)₂O₃.

Die gemäß der Erfindung vorgesehene semitransparente optische Funktionsschicht bzw. Funktionsschichten weisen in einem breiten wellenlängenbereich eine gezielt niedrige Transmission auf.

Das Bauelement kann so aufgebaut sein, daß es eine Vielzahl von Laserdioden und Lichtempfängern enthält, die zweckmäßig in einem Feld angeordnet sind.

Bei der Herstellung des neuen Bauelementes wird gemäß der Erfindung derart vorgegangen, daß zur Erzeugung der semitransparenten optischen Funktionsschicht entweder nach dem Abscheiden der die Laserdiode bildenden Halbleiterschichten und vor dem Abscheiden der den Lichtempfänger bildenden Halbleiterschichten oder nach dem Abscheiden der den Lichtempfänger bildenden Halbleiterschichten und vor dem Abscheiden der die Laserdiode bildenden Halbleiterschichten wenigstens eine weitere Schicht aus einem Halbleitermaterial gitterangepaßt epitaktisch abgeschieden wird; diese weitere Schicht wird erst nach dem Aufbringen der Halbleiterschichten des Lichtempfängers bzw. der Laserdiode einer seitlich einwirkenden chemischen Reaktion unterzogen.

Die zur Absenkung des Brechungsindexes der semitransparenten optischen Funktionsschicht bzw Funktionsschichten vorgesehene chemische Reaktion beinhaltet vorzugsweise eine Oxidation. Die Absenkung des Brechungsindexes durch chemische Oxidation tritt bei einer Vielzahl von Halbleitermaterialien auf. Daher ist eine Integration des Herstellungsprozesses der semitransparenten optischen Funktionsschicht in den Herstellungsprozeß des Bauelementes besonders einfach realisierbar. - Die Erfindung ist nicht auf ein bestimmtes Ausgangsmaterial für die Oxidation beschränkt. Als Ausgangsmaterial eignen sich jedoch bevorzugt AlAs oder Ga₁₋ₓAlₓAs. Hierbei ist es zweckmäßig, daß das Ga₁₋ₓAlₓAs einen Aluminiumgehalt von wenigstens 90% aufweist, das heißt, daß 0,9 ≤ x ≤ 1 ist.

Zwei Ausführungsbeispiele eines gemäß der Erfindung ausgebildeten und hergestellten Bauelementes sind in den Figuren 1 bis 3 dargestellt.

Dabei zeigt
- Fig. 1: einen Querschnitt durch ein Bauelement mit über der Laserdiode angeordnetem Lichtempfänger,
- Fig. 2: das in Fig. 1 dargestellte Bauelement mit Anschlüssen zu seiner Ansteuerung und
- Fig. 3: einen Querschnitt durch ein Bauelement mit über dem Empfänger angeordneter Laserdiode.

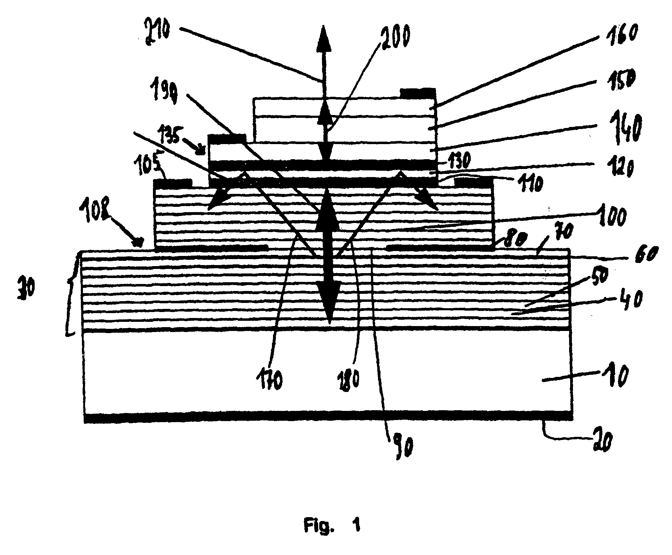

Die Fig. 1, 2 und 3 zeigen in vertikal gestreckten, nicht maßstabsgerechten Darstellungen einen Querschnitt durch einen etwa 20 µm breiten Bereich des jeweiligen Bauelements.

Das in Fig. 1 dargestellte Bauelement enthält ein Halbleitersubstrat 10. Das Halbleitersubstrat 10 weist eine Konzentration eines Dotierstoffs von ungefähr 10¹⁷ bis 10¹⁸ cm⁻³ auf. Bei dem Halbleitersubstrat 10 handelt es sich vorzugsweise um Galliumarsenid GaAs.

Auf einer Hauptfläche des Halbleitersubstrats 10 ist eine, einen elektrischen Kontakt bildende Metallschicht 20 aufgebracht. Die Metallschicht 20 besteht aus einer hochleitfähigen Metallegierung, wobei sich eine Gold-Germanium-Legierung besonders eignet.

Auf der anderen Hauptfläche des Halbleitersubstrats 10 befindet sich ein Bragg-Reflektor 30, der durch einen Schichtstapel aus Schichten 40, 50 gebildet ist. Der Schichtstapel ist dabei so aufgebaut, daß eine Schicht 40 mit einem hohen Brechungsindex mit einer Schicht 50 mit einem niedrigen Brechungsindex abwechselt. Der Bragg-Reflektor 30 beinhaltet vorzugsweise 20 bis 30 derartiger Schichtpaare. Um eine Sichtbarkeit der Schichten in der graphischen Darstellung zu ermöglichen, wurde nur ein Teil der Schichten 40 und 50 dargestellt.

Die Schichten 40 und 50 bestehen aus einem Halbleitermaterial, wobei sich AlₓGa₁₋ₓAs besonders eignet. Die Schichten 40 und 50 weisen durch einen unterschiedlichen Aluminiumgehalt unterschiedliche Brechungsindizes auf. Der Aluminiumgehalt x in der Verbindung AlₓGa₁₋ₓAs variiert vorzugsweise innerhalb des Bereichs von x = 1 bis x = 0,15. Die Dicke der Schichten 40, 50 beträgt jeweils ein Viertel des Produkts aus einer zu reflektierenden Wellenlänge und dem Brechungsindex der jeweiligen Schicht. Bei einer Emissionswellenlänge von beispielsweise 850 nm betragen die Schichtdicken daher für x = 1 ungefähr 70 nm und für x = 0,15 ungefähr 60 nm.

Die Schichten 40 und 50 sind mit einem Dotierstoff des n-Typs, beispielsweise Schwefel, Selen oder Tellur dotiert, wobei sich Tellur besonders eignet. Die Konzentration des Dotierstoffs beträgt etwa 2 mal 10¹⁸ cm⁻³.

Oberhalb des Bragg-Reflektors 30 befindet sich eine aktive Schicht 60. Die aktive Schicht 60 weist eine kleinere Bandlücke und somit eine höhere Ladungsträgerdichte auf als die an ihr anliegenden Schichten. Eine kleinere Bandlücke der aktiven Schicht 60 als der an ihr anliegenden Schichten wird bei der hier dargestellten Heterostruktur vorzugsweise dadurch gebildet, daß die aktive Schicht aus GaAs besteht. Eine Dotierung der aktiven Schicht 60 ist nicht erforderlich. Die aktive Schicht 60 ist vorzugsweise undotiert, jedoch führt eine Dotierung nicht zu einer wesentlichen Beeinträchtigung. Unterhalb der aktiven Schicht 60 befindet sich eine vorzugsweise n-dotierte Schicht aus Ga₁₋ₓAlₓAs und oberhalb der aktiven Schicht 60 eine Halbleiterschicht 70, beispielsweise aus p-dotiertem Ga₁₋ₓAlₓAs.

Oberhalb der aktiven Schicht 60 und der auf der aktiven Schicht 60 angeordneten Halbleiterschicht 70 befindet sich eine Isolationsschicht 80. Die Isolationsschicht 80 enthalt eine Öffnung 90, die auch als Aperturöffnung bezeichnet wird. Ein elektrischer Strom kann durch die Öffnung 90 von einem Kontakt, vorzugsweise einem Ringkontakt 105, in die aktive Zone des Lasers eindringen. Hierdurch wird im fertigen Bauelement eine Feldverteilung erzielt, durch die es zu einer Emission von Laserstrahlung in vertikaler Richtung kommt.

Oberhalb der Isolationsschicht 80 befindet sich ein weiterer Bragg-Reflektor 100. Der Bragg-Reflektor 100 weist einen ähnlichen Aufbau auf wie der untere Bragg-Reflektor 30. Vorzugsweise ist der Bragg-Reflektor 100 jedoch mit einem Dotierstoff dotiert, der einen dem Dotierstoff des unteren Bragg-Reflektors 30 entgegengesetzten Leitfähigkeitstyp hat. Beispielsweise kann der Bragg-Reflektor 100 mit Zink dotiert sein, wobei eine Dotierstoffkonzentration von etwa 2 bis 3 mal 10¹⁸ cm⁻³ bevorzugt ist. Ein weiterer möglicher Unterschied zwischen den Bragg-Reflektoren 30 und 100 ist ein gegebenenfalls unterschiedlicher Aluminiumgehalt der sie bildenden Schichten.

Die dargestellten Bereiche des Bauelementes bilden eine Laserdiode 108. Bei der Laserdiode 108 handelt es sich um eine Vertikalresonator-Laserdiode.

Oberhalb des weiteren Bragg-Reflektors 100 befinden sich drei Funktionsschichten 110, 120 und 130 aus einem nichtleitenden Material. Vorzugsweise bestehen die Funktionsschichten 110, 120 und 130 aus einem Halbleiteroxid, insbesondere aus Al₂O₃ oder aus (Ga₁₋ₓAlₓ)₂O₃ mit einen hohen Aluminiumgehalt von wenigstens 90%, das heißt mit x ≥ 0,9.

Auf den Funktionsschichten 110, 120 und 130 befindet sich eine Photodiode 135. Die Photodiode 135 ist vorzugsweise als pin-Diode ausgebildet und enthält drei Halbleiterschichten 140, 150 und 160. Die untere Halbleiterschicht 140 besteht vorzugsweise aus Ga₁₋ₓAlₓAs und ist beispielsweise mit Schwefel, Selen oder Tellur n-dotiert, wobei sich Tellur als Dotierstoff besonders eignet. Die mittlere Halbleiterschicht 150 besteht vorzugsweise aus GaAs und enthält keinen Dotierstoff. Die obere Halbleiterschicht 160, beispielsweise aus Ga₁₋ₓAlₓAs ist p-dotiert, wobei sich Zink als Dotierstoff besonders eignet.

Eine optische Isolation zum Abblocken der spontanen Emission des Lasers wird bei diesem Bauelement durch die Reflexion von Lichtstrahlen an Grenzflächen zwischen den Funktionsschichten 110, 120, 130 und einer angrenzenden Halbleiterschicht erreicht. Der große Brechzahlunterschied an diesen Grenzflächen sorgt dafür, daß der größte Teil von schräg auftreffenden spontan emittierten Lichtstrahlen 170, 180 wegen einer Totalreflexion die Grenzfläche nicht passieren kann. Dadurch wird verhindert, daß die spontane Emission einen störender Rauschstrom in der Photodiode 135 generiert. Die fast senkrecht auf die Grenzflächen auftreffenden Lichtstrahlen der spontanen Emission laufen ungefähr parallel zu einer optischen Lasermode 190. Der größte Teil dieser Lichtstrahlen wird bereits durch die Filterwirkung des Bragg-Reflektors 100 der Vertikalresonator-Laserdiode 108 abgeblockt, so daß der Strom der Photodiode 135 hauptsächlich durch die eintretende Laserstrahlung erzeugt wird.

Ein in der Photodiode 135 absorbierter Teil der Laserstrahlung ist mit.der Bezugsziffer 200 bezeichnet. Durch die Photodiode 135 tritt ein Ausgangslaserstrahl 210 nach außen.

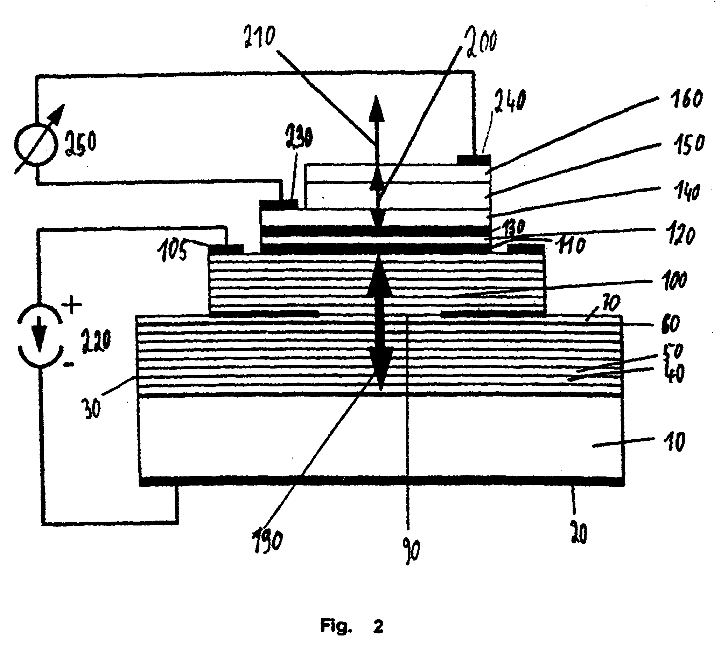

Die Vertikalresonator-Laserdiode 108 und die Photodiode 135 können völlig unabhängig voneinander an eine äußere elektrische Schaltung angeschlossen werden. Ein derartiger Anschluß ist in **Fig. 2** schematisiert dargestellt.

Eine Spannungsquelle 220 für die Laserdiode 108 ist an die Metallschicht 20 und den Ringkontakt 105 angeschlossen. Die Spannungsquelle 220 wird durch einen nicht dargestellten Regelkreis gesteuert. Der Regelkreis erfaßt einen in der Photodiode 135 fließenden Photostrom und steuert in Abhängigkeit von der Größe des Photostroms die Spannungsquelle 220. Die Größe des Photostroms wird durch eine Amperemeter 250 gemessen. Das Amperemeter 250 ist hierzu über Kontakte 230, 240 mit der Photodiode 135 verbunden. Hierdurch ist es möglich, die Ausgangsleistung der Laserdiode 108 in Abhängigkeit von dem in der Photodiode 135 fließenden Photostrom zu steuern.

Das in den **Fig.1 und 2** dargestellte Bauelement kann beispielsweise wie nachfolgend erläutert hergestellt werden.

Die Halbleiterschichten der Laserdiode 108 werden mit einem der bekannten Epitaxieverfahren auf dem Halbleitersubstrat 10 abgeschieden. Hierzu eignet sich insbesondere eine metallorganische Gasphasenepitaxie (Metall Organic Vapour Phase Epitaxy; MOVPE). Jedoch sind auch andere Epicaxieverfahren wie Molekurlarstrahlepitxie (Molecular Beam Epitaxy; MBE) geeignet. Anschließend werden die Halbleiterschichten der Laserdiode 108 strukturiert.

Die Funktionsschichten 110, 120 und 130 werden mit einem der bekannten Epitaxieverfahren gitterangepaßt zwischen den Halbleiterschichten der Laserdiode 108 und der Photodiode 135 auf Ga₁₋ₓAlₓAs-Substraten abgeschieden. Hierzu eignet sich insbesondere eine metallcrganische Gasphasenepitaxie (Metall Organic Vapour Phase Epitaxy; MOVPE). Jedoch sind auch andere Epitaxieverfahren wie Molekurlarstrahlepitxie (Molecular Beam Epitaxy; MBE) geeignet. Anschließend werden bei der Bauelementestrukturierung Mesastrukturen geätzt, an deren Seitenflanken die Funktionsschichten 110, 120 und 130 freigelegt sind. In einer naßchemischen Oxidation wird AlAs zur Bildung der Funktionsschichten 110, 120 und 130 bei einer Temperatur von ca. 400 °C in einer wasseradampf-gesättigten Stickstoff-Atmosphäre in elektrisch nichtleitendes Al₂O₃ umgewandelt.

Durch die vollständige selektive Oxidation einer oder mehrerer AlAs-Schichten zwischen den Halbleiterschichten der Photodiode 135 und den Schichten der Laserdiode 108 wird unmittelbar eine elektrische Isolation der Bauelemente voneinander erreicht.

Die Halbleiterschichten der Photodicde 135 werden gleichfalls mit einem der bekannten Epitaxieverfahren abgeschieden. Hierzu eignet sich wiederum insbesondere eine metallorganische Gasphasenepitaxie (Metall Organic Vapour Phase Epitaxy; MOVPE). Jedoch sind auch andere Epitaxieverfahren wie Molekurlarstrahlepitxie (Molecular Beam Epitaxy; MBE) geeignet. Anschließend werden die Halbleiterschichten der Photodiode 135 strukturiert.

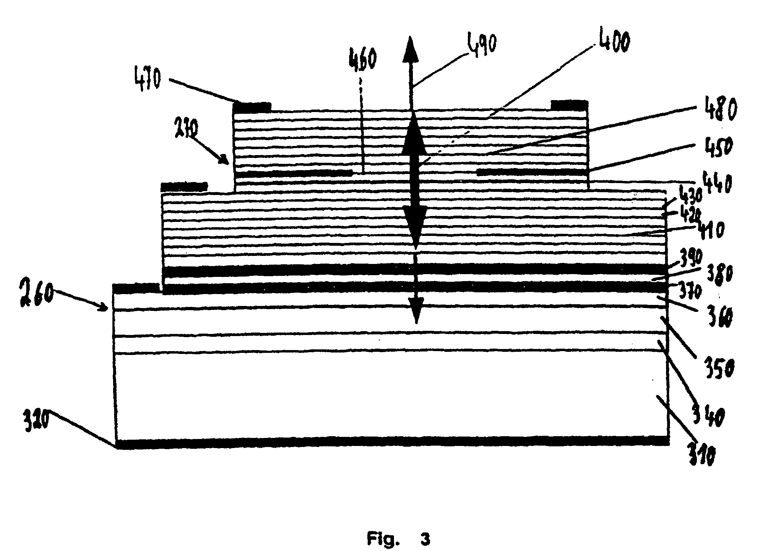

**Fig. 3** zeigt ein weiteres Ausführungsbeispiele der Erfindung. Während in **Fig. 1** die Photodiode 135 über der Vertikalresonator-Laserdiode 108 angeordnet ist, stellt **Fig. 3** eine Ausführungsform dar, bei der sich eine Photodiode 260 unterhalb einer Laserdiode 270 befindet.

Das in **Fig. 3** dargestellte Bauelement enthält ein Halbleitersubstrat 310. Das Halbleitersubstrat 310 weist eine Konzentration eines Dotierstoffs von ungefähr 10¹⁷ bis 10¹⁸ cm⁻³ auf. Bei dem Halbleitersubstrat 10 handelt es sich um Galliumarsenid GaAs.

Auf einer Hauptfläche des Halbleitersubstrats 310 ist eine, einen elektrischen Kontakt bildende Metallschicht 320 aufgebracht. Die Metallschicht 320 besteht aus einer hochleitfähigen Metallegierung, wobei sich eine Gold-Germanium-Legierung besonders eignet.

Auf der anderen Hauptfläche des Halbleitersubstrats 310 befindet sich eine Photodiode 260. Die Photodiode 260 ist vorzugsweise als pin-Diode ausgebildet und enthält drei Halbleiterschichten 340, 350 und 360. Die untere Halbleiterschicht 340 besteht vorzugsweise aus Ga₁₋ₓAlₓAs und ist beispielsweise mit Schwefel, Selen oder Tellur n-dotiert, wobei sich Tellur als Dotierstoff besonders eignet. Die mittlere Halbleiterschicht 350 besteht vorzugsweise aus GaAs und enthält keinen Dotierstoff. Die obere Halbleiterschicht 360, beispielsweise aus Ga₁₋ₓAlₓAs ist p-dotiert, wobei sich Zink als Dotierstoff besonders eignet.

Oberhalb der Photodiode 260 befinden sich drei Funktionsschichten 370, 380 und 390 aus einem nichtleitenden Material. Vorzugsweise bestehen die Funktionsschichten 370, 380 und 390 aus einem Halbleiteroxid, insbesondere aus Al₂O₃ oder aus (Ga₁₋ₓAlₓ)₂O₃ mit einen hohen Aluminiumgehalt von wenigstens 90%, das heißt mit x ≥ 0,9.

Eine optische Isolation zum Abblocken der spontanen Emission des Lasers wird bei diesem Bauelement durch die Reflexion von Lichtstrahlen an Grenzflächen zwischen den Funktionsschichten 370, 380, 390 und einer angrenzenden Halbleiterschicht erreicht. Der große Brechzahlunterschied an diesen Grenzflächen sorgt dafür, daß der größte Teil von schräg auftreffenden spontan emittierten Lichtstrahlen wegen einer Totalreflexion die Grenzfläche nicht passieren kann. Dadurch wird verhindert, daß die spontane Emission einen störender Rauschstrom in der Photodiode 260 generiert. Die fast senkrecht auf die Grenzflächen auftreffenden Lichtstrahlen der spontanen Emission laufen ungefähr parallel zu einer optischen Lasermode 400. Der größte Teil dieser Lichtstrahlen wird bereits durch die Filterwirkung eines Bragg-Reflektor 410 der Vertikalresonator-Laserdiode 270 abgeblockt, so daß der Strom der Photodiode 260 hauptsächlich durch die eintretende Laserstrahlung erzeugt wird.

Der Bragg-Reflektor 410 ist durch einen Schichtstapel aus Schichten 420, 430 gebildet. Der Schichtstapel ist dabei so aufgebaut, daß eine Schicht 420 mit einem hohen Brechungsindex mit einer Schicht 430 mit einem niedrigen Brechungsindex abwechselt. Der Bragg-Reflektor 410 beinhaltet vorzugsweise 20 bis 30 derartiger Schichtpaare. Um eine Sichtbarkeit der Schichten 420, 430 in der graphischen Darstellung zu ermöglichen, wurde nur ein Teil der Schichten 420, 430 dargestellt.

Die Schichten 420 und 430 bestehen aus einem Halbleitermaterial, wobei sich AlₓGa₁₋ₓAs besonders eignet. Die Schichten 420 und 430 weisen durch einen unterschiedlichen Aluminiumgehalt unterschiedliche Brechungsindizes auf. Der Aluminiumgehalt x in der Verbindung AlₓGa₁₋ₓAs variiert vorzugsweise innerhalb des Bereichs von x = 1 bis x = 0,15. Die Dicke der Schichten 420, 430 beträgt jeweils ein Viertel des Produkts aus einer zu reflektierenden Wellenlänge und dem Brechungsindex der jeweiligen Schicht.

Bei einer Emissionswellenlänge von beispielsweise 850 nm betragen die Schichtdicken daher für x = 1 ungefähr 70 nm und für x = 0,15 ungefähr 60 nm.

Die Schichten 420 und 430 sind mit einem Dotierstoff des n-Typs, beispielsweise Schwefel, Selen oder Tellur dotiert, wobei sich Tellur besonders eignet. Die Konzentration des Dotierstoffs beträgt etwa 2 mal 10¹⁸ cm⁻³.

Oberhalb des Bragg-Reflektors 410 befindet sich eine aktive Schicht 440. Die aktive Schicht 440 weist eine kleinere Bandlücke und somit eine höhere Ladungsträgerdichte auf als die an ihr anliegenden Schichten. Eine kleinere Bandlücke der aktiven Schicht 440 als der an ihr anliegenden Schichten wird bei der hier dargestellten Heterostruktur vorzugsweise dadurch gebildet, daß die aktive Schicht aus GaAs besteht. Eine Dotierung der aktiven Schicht 440 ist nicht erforderlich. Die aktive Schicht 440 ist vorzugsweise undotiert, jedoch führt eine Dotierung nicht zu einer wesentlichen Beeinträchtigung. Unterhalb der aktiven Schicht 440 befindet sich eine vorzugsweise n-dotierte Schicht aus Ga₁₋ₓAlₓAs und oberhalb der aktiven Schicht 440 eine Halbleiterschicht, beispielsweise aus p-dotiertem Ga₁₋ₓAlₓAs.

Oberhalb der aktiven Schicht 440 und der auf der aktiven Schicht 440 angeordneten Halbleiterschicht befindet sich eine Isolationsschicht 450. Die Isolationsschicht 450 enthält eine Öffnung 460, die auch als Aperturöffnung bezeichnet wird. Ein elektrischer Strom kann durch die Öffnung 460 von einem Kontakt, vorzugsweise einem Ringkontakt 470, in die aktive Zone des Lasers eindringen. Hierdurch wird im fertigen Bauelement eine Feldverteilung erzielt, durch die es zu einer Emission von Laserstrahlung in vertikaler Richtung kommt.

Oberhalb der Isolationsschicht 450 befindet sich ein weiterer Bragg-Reflektor 480. Der Bragg-Reflektor 480 weist einen ähnlichen Aufbau auf wie der untere Bragg-Reflektor 410.

Vorzugsweise ist der Bragg-Reflektor 480 jedoch mit einem Dotierstoff dotiert, der einen dem Dotierstoff des unteren Bragg-Reflektors 410 entgegengesetzten Leitfähigkeitstyp hat. Beispielsweise kann der Bragg-Reflektor 480 mit Zink dotiert sein, wobei eine Dotierstoffkonzentration von etwa 2 bis 3 mal 10¹⁸ cm⁻³ bevorzugt ist. Ein weiterer möglicher Unterschied zwischen den Bragg-Reflektoren 480 und 410 ist ein gegebenfalls unterschiedlicher Aluminiumgehalt der sie bildenden Schichten.

Aus der Laserdiode 270 tritt ein Ausgangslaserstrahl 490 nach außen.

Die Vertikalresonator-Laserdiode 270 und die Photodiode 260 können völlig unabhängig voneinander an eine äußere elektrische Schaltung angeschlossen werden. Dieser Anschluß sowie die Herstellung des Bauelementes können analog zu dem ersten, anhand der **Fig. 1** und **2** dargestellten Ausführungsbeispiel erfolgen.

In den hier beispielhaft beschriebenen Ausführungsformen der Erfindung wird die optische und elektrische Trennung der Photodiode 135; 260 von der Vertikalresonator-Laserdiode 108, 270 durch Zwischenschichten aus oxidiertem AlAs erreicht. Diese Zwischenschichten können jedoch selbstverständlich auch durch andere Schichten mit vergleichbaren optischen Eigenschaften ersetzt werden. Auch die anderen eingesetzten Materialien stellen vorteilhafte Realisierungsmöglichkeiten für den Aufbau eines erfindungsgemäßen Bauelementes dar. Sie können jedoch durch andere Materialien ersetzt werden. Die Erfindung ist nicht auf bestimmte Materialien oder Materialkombinationen beschränkt. Insbesondere können auch andere Halbleitermaterialien eingesetzt werden. Ebenso können die Arten der Dotierung vertauscht werden.

Eine Datenübertragung mit vielen verschiedenen Wellenlängen läßt sich dadurch erreichen, daß das Bauelement so ausgestaltet wird, daß es eine Vielzahl von Laserdioden und Lichtempfängern enthält, und daß die Laserdioden und Lichtempfänger in einem Feld angeordnet sind.

Diese Variante der Erfindung sieht also vor, in einem ei- oder zweidimensionalen Feld (array) mehrere Laserdioden 108, 270 nebeneinander anzuordnen. Auf beziehungsweise unter den einzelnen Laserdioden befindet sich jeweils ein die Sendeleistung der Laserdiode erfassender Lichtempfänger. Die von dem Lichtempfänger detektierte optische Sendeleistung der Laserdiode dient zu einer Ansteuerung dieser Laserdiode. Eine aus einer Laserdiode und einem Lichtempfänger gebildete Einheit bildet ein Einzelelement des Bauelementes.

In einer Array-Anordnung mit mehreren Vertikalresonator-Laserdioden 108 und Photodioden 135; 260 auf einem gemeinsamen Substrat kann auch eine elektrische Trennung zwischen den Einzelelementen erreicht werden. Dazu werden die Elemente auf einem elektrisch nicht leitfähigen Substrat, beispielsweise einem GaAs-Substrat, hergestellt, oder es werden isolierende Zwischenschichten zwischen den Halbleiterschichten der Bauelemente und dem Substrat eingebaut.

## Patentansprüche

1. Bauelement mit einem Substrat (10; 310), auf dem wenigstens eine als Lichtsender dienende Laserdiode (108) und wenigstens ein Lichtempfänger (135) monolithisch übereinander angeordnet sind,
- wobei sowohl die Laserdiode (108) als auch der Lichtempfänger (135) jeweils aus mehreren übereinander gitterangepaßt epitaktisch aufgewachsenen Halbleiterschichten besteht und
- wobei die Laserdiode (108) Licht mit einer Emissionswellenlänge λ emittiert und der Lichtempfänger (135) von dieser Laserdiode (108) emittiertes Licht empfängt,
**dadurch gekennzeichnet, daß** zwischen den Halbleiterschichten, die die Laserdiode (108) bilden, und den Halbleiterschichten, die den Lichtempfänger (135) bilden, wenigstens eine semitransparente optische Funktionsschicht (110, 120, 130; 370, 380, 390) zur optischen und elektrischen Entkopplung zwischen Laserdiode und Lichtempfänger monolithisch integriert ist, die aus einem gitterangepaßt epitaktisch abgeschiedenen und nachfolgend chemisch veränderten Halbleitermaterial besteht und einen Brechungsindex von höchstens 2,5 aufweist, wobei die der semitransparenten optischen Funktionsschicht (110, 120, 130; 370, 380, 390) benachbarte Halbleiterschicht der Laserdiode (108) einen im Vergleich mit der semitransparenten optischen Funktionsschicht (110, 120, 130; 370, 380, 390) größeren Brechungsindex aufweist.

2. Bauelement nach Anspruch 1 ,
**dadurch gekennzeichnet,**
**daß** die semitransparente optische Funktionsschicht (110, 120, 130; 370, 380, 390) ein Oxid eines Aluminium-haltigen Halbleitermaterials aufweist.

3. Bauelement nach Anspruch 2,
**dadurch gekennzeichnet,**
**daß** die semitransparente optische Funktionsschicht (110, 120, 130; 370, 380, 390) Al₂O₃ oder (Ga₁₋ₓAlₓ)₂O₃ enthält.

4. Bauelement nach einem der Ansprüche 1 bis 3,
**dadurch gekennzeichnet,**
**daß** es eine Vielzahl von Laserdioden (108) und Lichtempfängern (135) enthält und daß die Laserdioden (108) und Lichtempfänger (135) in einem Feld angeordnet sind.

5. Verfahren zur Herstellung eines Bauelements nach
einem der Ansprüche 1 bis 4, bei dem auf einer Hauptfläche eines Substrats (10; 310) monolithisch mehrere Halbleiterschichten gitterangepaßt epitaktisch abgeschieden werden,
**dadurch gekennzeichnet,**
**daß** zur Erzeugung der semitransparenten optischen Funktionsschicht (110, 120, 130; 370, 380, 390) entweder nach dem Abscheiden der die Laserdiode (108) bildenden Halbleiterschichten und vor dem Abscheiden der den Lichtempfänger (135) bildenden Halbleiterschichten oder nach dem Abscheiden der den Lichtempfänger (135) bildenden Halbleiterschichten und vor dem Abscheiden der die Laserdiode (108) bildenden Halbleiterschichten wenigstens eine weitere Schicht aus einem Halbleitermaterial gitterangepaßt epitaktisch abgeschieden wird und
**daß** diese weitere Schicht nach dem Aufbringen der Halbleiterschichten des Lichtempfängers bzw. der Laserdiode (108) einer seitlich einwirkenden chemischen Reaktion unterzogen wird.

6. Verfahren nach Anspruch 5,
**dadurch gekennzeichnet,**
**daß** die chemische Reaktion eine Oxidation beinhaltet.

## Claims

1. Component having a substrate (10; 310) on which at least one laser diode (108) serving as light transmitter and at least one light receiver (135) are arranged monolithically above one another,
- both the laser diode (108) and the light receiver (135) each comprising a plurality of semiconductor layers which have been grown on epitaxially above one another in lattice-matched form, and
- the laser diode (108) emitting light with an emission wavelength λ, and the light receiver (135) receiving light which is emitted by this laser diode (108),
**characterized in that** at least one semitransparent optical functional layer (110, 120, 130; 370, 380, 390) is monolithically integrated between the semiconductor layers which form the laser diode (108) and the semiconductor layers which form the light receiver (135) for the purpose of optical and electrical decoupling between laser diode and light receiver, which functional layer comprises a semiconductor material which has been deposited epitaxially in lattice-matched form and has then been chemically changed, and has a refractive index of at most 2.5, (that semiconductor layer of the laser diode (108) which adjoins the semitransparent optical functional layer (110, 120, 130; 370, 380, 390) having a greater refractive index than the semitransparent optical functional layer (110, 120, 130; 370, 380, 390).

2. Component according to Claim 1, **characterized in that** the semitransparent optical functional layer (110, 120, 130; 370, 380, 390) contains an oxide of an aluminium-containing semiconductor material.

3. Component according to Claim 2, **characterized in that** the semitransparent optical functional layer (110, 120, 130; 370, 380, 390) contains Al₂O₃ or (Ga₁₋ₓAlₓ)₂O₃.

4. Component according to one of Claims 1 to 3, **characterized in that** it comprises a multiplicity of laser diodes (108) and light receivers (135) and **in that** the laser, diodes (108) and light receivers (135) are arranged in an array.

5. Process for producing a component according to one of Claims 1 to 4, in which a plurality of semiconductor layers are epitaxially deposited monolithically and in lattice-matched form on a principal surface of a substrate (10; 310), **characterized in that** to form the semitransparent optical functional layer (110, 120, 130; 370, 380, 390) at least one further layer of a semiconductor material is epitaxially deposited in lattice-matched form either following the deposition of the semiconductor layers which form the laser diode (108) and before the deposition of the semiconductor layers which form the light receiver (135) or following the deposition of the semiconductor layers which form the light receiver (135) and before the deposition of the semiconductor layers which form the laser diode (108), and **in that** this further layer, following the application of the semiconductor layers of the light receiver or the laser diode (108), is subjected to a laterally acting chemical reaction.

6. Process according to Claim 5, **characterized in that** the chemical reaction comprises an oxidation.

## Revendications

1. Composant comprenant un substrat (10, 310) sur lequel sont superposés monolitiquement au moins une diode laser (108) servant d'émetteur de lumière et au moins un récepteur (135) de lumière,
- dans lequel tant la diode laser (108) que le récepteur (135) de lumière sont constitués de plusieurs couches semiconductrices superposées à réseau adapté et que l'on a fait croître par épitaxie et
- dans lequel la diode laser (108) émet de la lumière ayant une longueur d'onde λ d'émission et le récepteur (135) de lumière reçoit de la lumière émise par cette diode laser (108),
**caractérisé en ce qu'**il est intégré monolitiquement entre les couches semiconductrices qui forment la diode laser (108) et les couches semiconductrices qui forment le récepteur (135) de lumière au moins une couche (110, 120, 130, 370, 380, 390) fonctionnelle optique semitransparente de découplage optique et électrique entre la diode laser et le récepteur de lumière, couche fonctionnelle qui est déposée par épitaxie avec adaptation de réseau et qui est en un matériau semiconducteur modifié chimiquement ensuite et a un indice de réfraction de 2,5 au plus, la couche semiconductrice de la diode laser (108) qui est voisine de la couche (110, 120, 130, 370, 380, 390) fonctionnelle optique semitransparente ayant par rapport à la couche (110, 120, 130, 370, 380, 390) fonctionnelle optique semitransparente un indice de réfraction plus grand.

2. Composant suivant la revendication 1, **caractérisé en ce que** la couche (110, 120, 130, 370, 380, 390) fonctionnelle optique semitransparente comporte un oxyde d'un matériau semiconducteur contenant de l'aluminium.

3. Composant suivant la revendication 2, **caractérisé en ce que** la couche (110, 120, 130, 370, 380, 390) fonctionnelle optique semitransparente contient de l'Al₂O₃ ou du (Ga₁₋ₓAlₓ)₂O₃.

4. Composant suivant l'une des revendications 1 à 3, **caractérisé en ce qu'**il comporte une pluralité de diodes laser (108) et de récepteurs (135) de lumière et **en ce que** les diodes laser (108) et les récepteurs (135) dé lumière sont disposés suivant un champ.

5. Procédé de production d'un composant suivant l'une des revendications 1 à 4, dans lequel on dépose par épitaxie avec adaptation de réseau sur l'une des étapes principales d'un substrat (10, 310) monolitiquement plusieurs couches semiconductrices,
**caractérisé en ce que** pour la production de la couche (110, 120, 130, 370, 380, 390) fonctionnelle optique semitransparente, on dépose par épitaxie avec adaptation de réseau, soit après le dépôt des couches semiconductrices formant la diode laser (108) et avant le dépôt des couches semiconductrices formant le récepteur (135) de lumière, soit après le dépôt des couches semiconductrices formant le récepteur (135) de lumière et avant le dépôt des couches semiconductrices formant la diode laser (108) au moins une autre couche en un matériau semiconducteur et on soumet cette autre couche après le dépôt des couches semiconductrices du récepteur de lumière ou de la diode laser (108) à une réaction chimique agissant latéralement.

6. Procédé suivant la revendication 5, **caractérisé en ce que** la réaction chimique comprend une oxydation.
